# EUROPÄISCHE PATENTSCHRIFT

(11) **EP 3 736 688 B1**
(45) Veröffentlichungstag und Bekanntmachung des Hinweises auf die Patenterteilung: **11.01.2023**
(21) Anmeldenummer: 19210226.7
(22) Anmeldetag: 20.11.2019
(51) Int. Cl.: G06F 8/10, G06F 11/26, G06F 30/20, G06F 30/15, G06F 30/3308

(54) **VIRTUELLES STEUERGERÄT**
VIRTUAL CONTROL DEVICE
APPAREIL DE COMMANDE VIRTUEL

(30) Priorität: 08.05.2019 DE 102019111953
(43) Veröffentlichungstag der Anmeldung: 11.11.2020
(73) Patentinhaber: dSPACE GmbH, 33102 Paderborn (DE)
(72) Erfinder: Süvern, Markus, 33102 Paderborn (DE); Kiffmeier, Ulrich, Dr., 33102 Paderborn (DE); Church, Stuart Michael, 33102 Paderborn (DE)

(56) Entgegenhaltungen:
- EP-A1- 3 001 313
- EP-A1- 3 336 730
- EP-A1- 3 454 234
- KURTZ ANDREAS ET AL: "Comparing system- and test model with integrated software-based signal simulation", 2016 4TH INTERNATIONAL CONFERENCE ON MODEL-DRIVEN ENGINEERING AND SOFTWARE DEVELOPMENT (MODELSWARD), SCITEPRESS, 19 February 2016 (2016-02-19), pages 656-662, XP033106956, DOI: 10.5220/0005751006560662 [retrieved on 2017-06-20]

## Beschreibung

Die Erfindung betrifft ein virtuelles Steuergerät nach dem AUTOSAR-Standard.

Des Weiteren betrifft die Erfindung ein Verfahren zum Testen einer Steuerungssoftware eines Steuergeräts.

Für Funktionstests von Software von elektronischen Steuergeräten (ECUs) kann grundsätzlich Hardware in Form des Steuergerätes oder in Form eines Steuergeräteprototyps eingesetzt und die Steuerungssoftware im realen Versuch, z.B. im realen Fahrversuch getestet werden. Bei solchen Tests ist allerdings, neben den hohen Kosten und dem sehr hohen Zeitaufwand, die fehlende Reproduzierbarkeit, aufgrund der komplexen Umweltbedingungen, problematisch.

Weiterhin bieten sich sogenannte Hardware in the Loop (HiL) Tests an, bei dem das Steuergerät über Ein- und Ausgänge an einen HiL-Simulator angeschlossen wird, wobei der HiL-Simulator die reale Umgebung nachbildet. Der HiL-Simulator emuliert die elektrischen Signale von Sensoren und Aktoren, die vom Steuergerät gelesen werden. Beispielsweise werden bei einem HiL-Test eines Verbrennungsmotors die Signale von Kurbel- und Nockenwellensensoren von einer Angular Processing Unit (APU) erzeugt, die Teil der Hardware des HiL-Simulators ist. Das Steuergerät wiederum generiert auf Basis dieser Signale mittels der Steuerungssoftware Sensor- und/oder Aktorsteuersignale, die wiederum zu einer Änderung der elektrischen Signale im HiL-Simulator führen. Die vom HiL-Simulator emulierten elektrischen Signale werden mittels eines Umgebungsmodells erzeugt, welches die benötigten Signale abbildet, also die gesamte Umgebung. Das Umgebungsmodell beinhaltet neben der eigentlichen Regelstrecke noch zusätzlich so genannte Störmodelle, die auf den Regelkreis einwirken, also z.B. wechselnde Umgebungsbedingungen wie Temperatur, Gegenwind, Fahrbahnunebenheit, Sensorsignalfehler wie elektrische Störungen und Lenkbewegungen des Fahrer-(modells). Die Strecke, die im realen Fahrversuch als Versuchsstrecke abgefahren und so unterschiedliche elektrische Signale für das Steuergerät generieren würde, wird innerhalb der HiL-Simulation somit im Umgebungsmodell abgebildet. Um einen HiL-Test durchzuführen, muss allerdings die Entwicklung eines Steuergerätes schon relativ weit fortgeschritten sein, da das Steuergerät über seine Hardware an den HiL-Simulator angeschlossen wird.

Um frühere Test der Steuerungssoftware zu ermöglichen, beispielsweise zu einem Entwicklungszeitpunkt, zu dem noch keine Steuergeräte-Hardware vorliegt, sind Hardwareunabhängige Softwaretests erforderlich. Hierfür haben sich virtuelle Steuergeräte, auch V-ECUs genannt, etabliert. Mittels eines virtuellen Steuergerätes wird in einem Simulationsszenario ein echtes Steuergerät emuliert. Ein virtuelles Steuergerät enthält somit noch nicht die dafür vorgesehene Steuergeräte-Hardware, sondern besteht aus der Steuerungssoftware eines echten Steuergeräts und Modulen zur Anbindung der Steuergerätesoftware an eine Simulationsplattform.

In EP 3 336 730 A1 ist beschrieben, wie Modelle, also Komponenten eines virtuellen Steuergeräts, die für eine Simulationsplattform inkompatibel sind, durch eine Einkapselung des mit der Simulationsplattform inkompatiblen Modells in eine kompatible Container-Einheit für die Simulationsplattform ansprechbar gemacht werden.

Weiterhin zeigt EP 3 454 234 A1 wie zu Simulationszwecken ein Verbund aus einem virtuellen Steuergerät und einem echten Steuergerät in Echtzeit simuliert werden kann.

In Kurtz, Andreas et AL: "Comparing system- and test model with integrated software-based signal simulation", 4th International Conference on Model-Driven Engineering and Software Development, SCITEPRESS, 19. Februar 2016 (2016-02-19), Seiten 656-662, DOI: 10.5220/0005751006560662 ist beschrieben, wie zu einer Basis-Softwarekomponente passende Testwerte über einen Simulationsagenten in eine Basis-Softwarekomponente eingeschleust werden können.

Um möglichst realitätsnahe virtuelle Steuergeräte zu erstellen und die Software durch reproduzierbare Tests abzusichern, kann ein virtuelles Steuergerät auf Basis der Steuerungssoftware des echten Steuergerätes erstellt werden. Dabei müssen natürlich einige Komponenten der Steuerungssoftware des echten Steuergerätes an die virtuelle Umgebung der Simulationsplattform angepasst werden.

So muss beispielsweise die Steuergeräte-Hardware durch Simulation ersetzt werden. Dies kann mit Hilfe eines Hypervisors erfolgen, der die Steuergeräte-Hardware nachbildet und an die Simulationsumgebung angeschlossen ist, wie dies in EP 3 001 313 A1 beschrieben ist.

Eine andere Möglichkeit ist es, die Steuergeräte-Hardware bzw. an das Steuergerät anzuschließende externe Hardware in einem Umgebungsmodell nachzubilden, welches an die Simulationsplattform angeschlossen ist.

Dies führt allerdings dazu, dass die Anschlüsse bzw. Schnittstellen eines realen Steuergeräts und eines virtuellen Steuergerätes an ein Umgebungsmodell bzw. einen Hypervisor unterschiedlich sind und damit die Wiederverwendung von Umgebungsmodellen für frühe Softwaretests mittels virtueller Steuergeräte und HiL-Tests erschwert wird. Bisher wird ein virtuelles Steuergerät im Computer zur Simulation mit verschiedenen Komponenten, wie virtuellen Sensoren, Aktuatoren und Steuergeräte-Netzwerken verbunden. Die virtuellen Sensoren, Aktuatoren und/oder Steuergeräte-Netzwerke, also die virtuellen Hardware-Komponenten, sind dabei in das Umgebungsmodell als Hardware-Komponenten-Modell integriert. Beispielsweise ist ein virtueller Sensor als Sensormodell in das Umgebungsmodell integriert. So kann das Umgebungsmodell für einen HiL-Test des Verbrennungsmotors nicht direkt für den Softwaretest mittels des virtuellen Steuergerätes wiederverwendet werden, sondern es muss um Simulationen von Kurbelund Nockenwellensensoren, also um das Kurbelwellensensormodell bzw. das Nockenwellensensormodell, erweitert werden, um es an die Schnittstelle des virtuellen Steuergerätes anzupassen. Somit lassen sich die Umgebungsmodelle für HiL-Tests nur schwer für Softwaretests mittels virtueller Steuergeräte verwenden und umgekehrt.

Des Weiteren führt die Integration der Sensormodelle und/oder Aktuatormodelle in das Umgebungsmodell dazu, dass bei hohen Berechnungsraten der Sensormodelle, die gegebenenfalls für eine hohe Genauigkeit notwendig sind, sich die gesamte Simulation stark verlangsamt, da aufgrund der Integration in das Umgebungsmodell auch das Umgebungsmodell mit der hohen Berechnungsrate berechnet wird. Für die Simulation von Sensoren sind unter Umständen Berechnungsraten im Mikrosekundenbereich notwendig, um die Zeitpunkte von Signaländerungen genau zu erfassen. Eine aufwändige Schrittweitensteuerung der Simulation wäre zwar auch möglich, verhindert aber die Wiederverwendung des Umgebungsmodells unter Echtzeitbedingungen am HiL-Simulator.

Ausgehend von dieser Problematik ist es Aufgabe der Erfindung, ein virtuelles Steuergerät bereitzustellen, das die oben beschriebenen Nachteile vermeidet. Insbesondere sollen eine einfache Verwendung der Umgebungsmodelle für HiL-Tests und Softwartest ermöglicht sowie die Simulation beschleunigt werden.

Diese Aufgabe wird durch die Merkmale der unabhängigen Patentansprüche gelöst. Bevorzugte Weiterbildungen finden sich in den Unteransprüchen.

Erfindungsgemäß wird somit ein virtuelles Steuergerät nach dem AUTOSAR-Standard bereitgestellt, mit einem Service-Layer, einem ECU Abstraction-Layer und einem Microcontroller Abstraction-Layer, wobei das virtuelle Steuergerät zusätzlich einen Hardware-Layer aufweist, der zur Simulation wenigstens einer Hardware-Komponente eingerichtet ist.

Die Schnittstellen zwischen Software und Hardware in einem Steuergerät bilden die Registerzugriffe des Mikrocontrollers. Alle Hardware-Komponenten, auf die der Mikrocontroller mittels solcher Registerzugriffe zugreift, können im Sinne der Erfindung eine Hardware-Komponente sein. Folglich sind Hardware-Komponenten im Sinne der Erfindung beispielsweise externe Sensoren und Aktoren außerhalb des Steuergerätes, Sensoren und Aktoren, die auf der Steuergeräte-Platine verbaut sind, interne Komponenten des Mikrocontrollers selber, z.B. eine Angular Processing Unit (APU).

AUTOSAR (AUTomotive Open System ARchitecture) ist eine offene und standardisierte Softwarearchitektur für elektronische Steuergeräte (ECUs), mit dem Ziel, Software in Fahrzeugen unterschiedlicher Hersteller und Elektronikkomponenten verschiedener Anbieter einzusetzen. Das Hauptkonzept der AUTOSAR Softwarearchitektur ist die Trennung von hardwareunabhängiger Anwendungssoftware und hardwareorientierter Basissoftware (BSW) mittels des Software Abstraction Layers (Runtime environment, RTE). Diese Softwarearchitektur ermöglicht durch die Trennung, dass eine komponentenorientierte, hardwareunabhängige Softwarestruktur auf Anwendungsebene ohne spezifische Kenntnisse der verwendeten oder geplanten Hardware entwickelt werden kann.

Die Basissoftware (BSW) innerhalb der AUTOSAR-Softwarearchitektur weist die folgenden Schichten, bezeichnet als Layer, auf: Service-Layer, ECU Abstraction-Layer und Microcontroller Abstraction-Layer (MCAL). Die Basissoftware wird weiterhin in unterschiedliche Basissoftwaremodule unterteilt. Der MCAL ist die unterste Schicht der Basissoftware. Bei realen Steuergeräten wird der Zugriff auf den Mikrocontroller des Steuergerätes über den MCAL geleitet. Der MCAL enthält Treiber mit direktem Zugriff auf die internen Peripheriegeräte des Mikrocontrollers und versorgt die weiteren Komponenten der Basissoftware mit mikrocontrollerunabhängigen Werten. Der MCAL ist somit ein hardwarespezifischer Layer, der eine Standardschnittstelle zur Basissoftware sicherstellt. Beim Erstellen eines virtuellen Steuergerätes, auch V-ECU genannt, ausgehend von der Steuerungssoftware eines realen Steuergerätes müssen somit einige Module des MCAL ausgetauscht werden, um statt einer Ausführung auf der realen Steuergeräte-Hardware eine Simulation in der virtuellen Umgebung mittels einer Simulationsplattform zu ermöglichen.

Bisher werden bei Softwaretests mittels virtueller Steuergeräte die Hardware-Komponenten-Modelle, also beispielsweise die Sensormodelle und Aktuatormodelle, bei der Simulation in das Umgebungsmodell integriert. Der Kern der Erfindung liegt nun darin, das virtuelle Steuergerät mit einer zusätzlichen Schicht, also einem zusätzlichen Hardware-Layer, zu erweitern, der zur Simulation wenigstens einer Hardware-Komponente eingerichtet ist. Somit können bei einer Simulation die virtuellen Hardware-Komponenten direkt im Kontext des virtuellen Steuergerätes simuliert werden. Die virtuelle Hardware-Komponente ist als Hardware-Komponenten-Modell in dem Hardware-Layer des virtuellen Steuergerätes integriert. Beispielsweise kann bei einer Simulation eines Sensors der Sensor als virtueller Sensor direkt von dem virtuellen Steuergerät simuliert werden, wobei der virtuelle Sensor als Sensormodell in dem virtuellen Steuergerät integriert ist. Das Sensormodell bzw. das Hardware-Komponenten-Modell berechnet für jedes Eingangssignal das Verhalten, d.h. den zugehörigen Ausgabewert und somit das Ergebnis der Simulation der Hardware-Komponente. Dadurch ergeben sich gleiche Anschlüsse bzw. Schnittstellen des virtuellen Steuergerätes an das Umgebungsmodell wie beim realen Steuergerät. So vereinfacht sich auch das Verwenden des Umgebungsmodells des HiL-Tests für den Softwaretest mittels des virtuellen Steuergerätes und umgekehrt.

Des Weiteren ermöglicht die Integration der Hardware-Komponenten-Modelle, also beispielsweise der Aktuatormodelle und/oder Sensormodelle, dass die Berechnungsrate des Hardware-Komponenten-Modells unabhängig von der Berechnungsrate des Umgebungsmodells gewählt werden kann. Eine hohe Berechnungsrate des Hardware-Komponenten-Modells, die gegebenenfalls für eine hohe Genauigkeit gewählt wird, wirkt sich somit kaum erhöhend auf die Gesamtsimulationszeit aus. Somit ermöglicht der zusätzliche Hardware-Layer eine signifikante Erhöhung der Simulationsgeschwindigkeit.

In einer bevorzugten Weiterbildung der Erfindung ist vorgesehen, dass der Hardware-Layer mehrere Hardware-Layer-Module umfasst, die gemäß dem AUTOSAR-Standard wie ein Basissoftwaremodul ausgestaltet sind. Wie bereits erwähnt sieht der AUTOSAR-Standard für die Basissoftware vor, dass sie in unterschiedliche Basissoftwaremodule unterteilt ist. Unter einem Modul ist dabei eine funktionale Einheit an Software zu verstehen. Dadurch dass der Hardware-Layer mehrere Hardware-Layer-Module umfasst und die Hardware-Layer-Module jeweils nach dem AUTOSAR-Standard wie ein Basissoftwaremodul ausgestaltet sind, können die Hardware-Layer-Module auch auf die gleiche Weise in das virtuelle Steuergerät eingebunden werden, wie die Basissoftwaremodule. Weiterhin führt dies dazu, dass die Hardware-Layer-Module wie die Basissoftwaremodule konfiguriert werden können. So können Bibliotheken für die Hardware-Komponenten-Modelle bereitgestellt werden, aus denen der Benutzer ein Hardware-Komponenten-Modul auswählen kann. Dieses muss der Benutzer nur noch wie ein Basissoftwaremodul integrieren und konfigurieren. Es ist also nicht notwendig, dass der Anwender die Funktionalität der Hardware-Komponente modelliert oder dass der Anwender die simulierte Hardware-Komponente in die Kommunikation mit dem virtuellen Steuergerät aufwändig händisch einbindet. Der Anwender braucht ein Hardware-Layer-Modul nur noch wie ein Basissoftwaremodul zu konfigurieren.

In diesem Zusammengang ist gemäß einer weiteren bevorzugten Weiterbildung der Erfindung vorgesehen, dass jeweils ein Hardware-Layer-Modul zur Simulation jeweils einer Hardware-Komponente eingerichtet ist. Somit lassen sich durch das gezielte Einbinden der Hardware-Layer-Module genau die Hardware-Komponenten simulieren, die für das spezifische reale Steuergerät relevant sind. Beispielsweise soll die Steuerungssoftware des Steuergerätes, das für die Steuerung eines Verbrennungsmotors zuständig ist, getestet werden. Das reale Steuergerät bekommt Signale eines Kurbelwellensensors sowie eines Nockenwellensensors. Für den Softwaretest mittels des virtuellen Steuergerätes kann also gezielt ein Hardware-Layer-Modul zur Simulation des Kurbelwellensensors und ein weiteres Hardware-Layer-Modul zur Simulation des Nockenwellensensors verwendet werden. Der virtuelle Kurbelwellensensor und der virtuelle Nockenwellensensor sind dabei jeweils als Hardware-Komponenten-Modell, also als Kurbelwellensensormodell und als Nockenwellensensormodell, in den jeweiligen Hardware-Layer-Modulen des virtuellen Steuergeräts integriert. Diese Ausgestaltung führt somit zu einer großen Modularität und Flexibilität, die insbesondere die Anwendung vereinfacht.

Wie bereits erwähnt ist die Basissoftware innerhalb der AUTOSAR-Softwarearchitektur in mehrere Layer unterteilt, wobei einer davon der Microcontroller Abstraction-Layer (MCAL) ist. In diesem Zusammenhang ist in einer bevorzugten Weiterbildung der Erfindung vorgesehen, dass der Microcontroller Abstraction-Layer mehrere MCAL-Module umfasst, wobei die MCAL-Module mit den Hardware-Layer-Modulen verbindbar sind. Ein MCAL Modul ermöglicht den hardwarespezifischen Zugriff auf die Hardware eines Microcontrollers mittels einer standardisierten Schnittstelle. Durch die MCAL Module werden Eigenheiten des Mikrocontrollers gekapselt und diverse Treiberfunktionen realisiert, z.B. für Buszugriffe und Eingabe-Ausgabe-Zugriffe, so genannte IO-Zugriffe. Beim Einbinden der Hardware-Layer-Module in das virtuelle Steuergerät, werden die Hardware-Layer-Module also mit den MCAL-Modulen des Microcontroller Abstraction-Layers verbunden. Insbesondere wird für die Implementierung der Hardware-Layer-Module der gleiche Entwicklungsprozess nach AUTOSAR genutzt wie für den Rest der Steuergerätesoftware. Dies erleichtert dem Benutzer das Implementieren bzw. Einbinden eines entsprechenden Hardware-Layer-Moduls in ein virtuelles Steuergerät.

Beim Verbinden eines Hardware-Layer-Moduls mit einem MCAL-Modul kann vorgesehen sein, dass jeweils ein Hardware-Layer-Modul mit jeweils einem MCAL-Modul verbunden wird, dass jeweils ein Hardware-Layer-Modul mit mehreren MCAL-Modulen verbunden wird, oder dass mehrere Hardware-Layer-Module mit dem gleichen MCAL-Modul verbunden werden. Natürlich ist auch jegliche Kombination der genannten Varianten möglich. Es liegt also eine enge Verzahnung des Hardware-Layers mit dem Microcontroller Abstraction-Layer vor. Da der Microcontroller Abstraction-Layer beim virtuellen Steuergerät die Schnittstelle zur Simulationsplattform darstellt, ist die Simulation der Hardware-Komponente effizient und einfach zu nutzten.

In einer weiteren bevorzugten Weiterbildung der Erfindung ist vorgesehen, dass der Hardware-Layer derart ausgestaltet ist, dass Ereignisse innerhalb des virtuellen Steuergerätes erzeugbar sind. Unter einem Ereignis, auch Event genannt, wird im Sinne der Erfindung ein Zeitpunkt verstanden, an dem der normale Programmablauf unterbrochen wird. Beispielsweise kann für einen Sensor als simulierte Hardware-Komponente innerhalb des Hardware-Layers ein Sensorevent erzeugt werden. Dabei ist insbesondere vorgesehen, dass das Ereignis mit einer hohen zeitlichen Genauigkeit erzeugt werden kann. Dies bedeutete insbesondere, dass der Zeitstempel, der zu diesem Ereignis gehört, eine hohe Genauigkeit aufweist.

In Zusammenhang mit einer vielseitigen Verwendung des virtuellen Steuergerätes ist erfindungsgemäß vorgesehen, dass der Hardware-Layer derart eingerichtet ist, dass die Hardware-Komponente mit unterschiedlicher Berechnungsrate simulierbar ist. Während der Simulation werden von der simulierten Hardware-Komponente Signale erzeugt und diese Signale werden vom virtuellen Steuergerät verarbeitet. Der Austausch der Signale erfolgt in einer vorbestimmten Frequenz, die auch als Berechnungsrate bezeichnet wird. Bei einer Simulation der Hardware-Komponente mit einer hohen Berechnungsrate, d.h. bei einer hohen Berechnungsrate des Hardware-Komponenten-Modells, ist die Zeitspanne, die zwischen zwei aufeinanderfolgenden Zeitpunkten des simulierten Prozesses liegt gering. Beispielsweise beträgt bei einer Berechnungsrate von 50 kHz die Periodendauer 20 Mikrosekunden. Bei einigen simulierten Hardware-Komponenten ist eine so hohe Berechnungsrate des Hardware-Komponenten-Modells für eine ausreichende Genauigkeit notwendig, da sich der simulierte Prozess schnell ändert. Wenn beispielsweise eine Motorregelung mit Kurbelwellensensor simuliert werden soll, muss die Berechnungsrate des Kurbelwellensensormodells hoch genug sein, um bei Motordrehzahlen von 6000 U/min noch realistische Ergebnisse zu liefern. Denn während einer Periodendauer von 20 Mikrosekunden findet immer noch eine Umdrehung der Kurbelwelle um 0,72 Grad statt, was bezogen auf den Einspritzzeitpunkt (ca. 6 Grad vor dem oberen Totpunkt) ein signifikanter Wert ist. Bei anderen Hardware-Komponenten kann im Übrigen auch eine geringere Berechnungsrate des Hardware-Komponenten-Modells für ein realistisches Ergebnis ausreichend sein. Insofern ist es für eine vielseitige Verwendung des virtuellen Steuergerätes von großem Vorteil, dass der Hardware-Layer derart eingerichtet ist, dass die wenigstens eine Hardware-Komponente mit unterschiedlicher Berechnungsrate simulierbar ist. Mit anderen Worten bedeutet dies, dass die Berechnungsrate des Hardware-Komponenten-Modells frei gewählt werden kann.

In Zusammenhang mit dem modularen Aufbau des virtuellen Steuergerätes ist gemäß einer bevorzugten Weiterbildung der Erfindung vorgesehen, dass der Hardware-Layer zur Simulation mehrerer Hardware-Komponenten eingerichtet ist, wobei die einzelnen Hardware-Komponenten gleichzeitig mit unterschiedlichen Berechnungsraten simulierbar sind. Dies ist auch insbesondere im Hinblick auf die Gesamtzeit der Simulation von Bedeutung. Wenn beispielsweise zwei Sensoren als Hardware-Komponenten simuliert werden sollen und der eine Sensor für realistische Ergebnisse mit einer hohe Berechnungsrate simuliert wird, kann der andere Sensor trotzdem mit einer geringeren Berechnungsrate simuliert werden. Wäre dies nicht möglich und beide Sensoren müssten mit der gleichen Berechnungsrate simuliert werden, würde dies die Simulationszeit unnötig verlängern. Denn eine hohe Berechnungsrate des Hardware-Komponenten-Modells führt auch dazu, dass für eine bestimmte Zeitspanne des simulierten Prozesses mehr Berechnungsschritte durchgeführt werden müssen.

Um auf das Beispiel der Motorregelung mit Kurbelwellensensor zurückzukommen: Um die Zeitspanne des Prozesses, der einer Umdrehung (360 Grad) der Kurbelwelle entspricht, zu simulieren, müssen bei einer Motordrehzahl von 6000 U/min (=10ms pro Umdrehung) und einer Berechnungsrate von 50 kHz (Periodendauer 20 Mikrosekunden) 500 Berechnungsschritte durchgeführt werden. Müssten alle Hardware-Komponenten-Modelle, also auch das Sensormodell des zweiten Sensors, bei dem für realistische Ergebnisse gar keine so hohe Berechnungsrate notwendig ist, mit dieser Berechnungsrate berechnet werden, würden beim zweiten Sensormodell mehr Berechnungsschritte als notwendig durchgeführt werden. Dies würde zu einer längeren Simulationszeit führen. Dass also jedes einzelne Hardware-Komponenten-Modell, unabhängig der anderen Hardware-Komponenten-Modelle, mit einer eigenen Berechnungsrate berechnet werden kann, führt insgesamt dazu, dass die Gesamtzeit, die eine Simulation in Anspruch nimmt, nicht durch hohe Berechnungsraten einzelner simulierter Hardware-Komponenten unnötig verlängert wird.

Weiterhin ist erfindungsgemäß vorgesehen, dass das virtuelle Steuergerät zur Simulation mit einem Umgebungsmodell verbunden ist, wobei während der Simulation eine Berechnungsrate des Umgebungsmodells von einer Berechnungsrate eines Hardware-Komponenten-Modells abweicht. Unter Umgebungsmodell wird im Sinne der Erfindung z.B. auch die Simulation der Fahrstrecke, die in einem realen Fahrversuch mit einem realen Steuergerät abgefahren würde, verstanden, also die Fahrstrecke und ihrer Eigenheiten, wie zum Beispiel ihre Steigung, generieren Signale, die von der realen Steuereinheit verarbeitet werden. Dies wird während der Simulation ebenfalls abgebildet. Das Umgebungsmodell tauscht also während der Simulation Signale mit dem virtuellen Steuergerät aus. Die im obigen Abschnitt dargelegten Zusammenhänge zwischen den Berechnungsraten der einzelnen Hardware-Komponenten-Modelle und der Simulationszeit treffen ebenfalls auf die Berechnungsrate des Umgebungsmodells zu. Insofern führt das Abweichen der Berechnungsrate des Umgebungsmodells von der Berechnungsrate des Hardware-Komponenten-Modells während der Simulation dazu, dass die Simulationszeit nicht durch hohe Berechnungsraten einzelner simulierter Hardware-Komponenten unnötig verlängert wird. Somit verringert sich die Simulationszeit.

In diesem Zusammenhang ist gemäß einer bevorzugten Weiterbildung der Erfindung vorgesehen, dass das virtuelle Steuergerät zur Simulation mit einem Umgebungsmodell verbindbar ist, wobei während der Simulation zwischen dem Umgebungsmodell und dem virtuellen Steuergerät Signale auf einem physikalischen Niveau ausgetauscht werden. Insbesondere werden zwischen dem Umgebungsmodell und dem virtuellen Steuergerät keine TTL-Signale ausgetauscht, also digitale Signale, deren Logikwerte über elektrische Spannungen repräsentiert werden. Stattdessen werden zwischen dem Umgebungsmodell und dem virtuellen Steuergerät Signale auf physikalischem Niveau, also zum Beispiel Umdrehungsraten in der Einheit Grad/Sekunde, oder elektrische Spannungswerte in der Einheit Volt ausgetauscht. Somit kann für den Test eines virtuellen Steuergerätes das gleiche Umgebungsmodell wie für einen HiL-Test verwendet werden, da bei HiL-Tests ebenfalls Signale auf physikalischem Niveau ausgetauscht werden.

Hinsichtlich einer Rate, mit der die Signale zwischen dem Umgebungsmodell und dem virtuellen Steuergerät übertragen werden, ist erfindungsgemäß vorgesehen, dass die Rate, mit der die Signale zwischen dem Umgebungsmodell und dem virtuellen Steuergerät übertragen werden, kleiner oder gleich der Berechnungsrate des Umgebungsmodell ist. Es ist also durchaus möglich, dass innerhalb des virtuellen Steuergerätes eine Hardware-Komponente mit einer hohen Berechnungsrate simuliert wird, die Rate, mit der die Signale vom Umgebungsmodell und dem virtuellen Steuergerät während der Simulation ausgetauscht werden, aber geringer ist. Somit lässt sich die Simulationszeit stark verringern.

Die Erfindung betrifft weiterhin ein Verfahren zum Testen einer Steuerungssoftware eines Steuergeräts, wobei die Steuerungssoftware in ein nach dem AUTOSAR-Standard arbeitendes virtuelles Steuergerät eingebunden wird, wobei das virtuelle Steuergerät einen Service-Layer, einen ECU Abstraction-Layer und einen Microcontroller Abstraction-Layer aufweist und wobei das virtuelle Steuergerät zusätzlich einen Hardware-Layer aufweist, mit dem wenigstens eine Hardware-Komponente simuliert wird.

Das erfindungsgemäße Verfahren ermöglicht einen Hardware-unabhängigen Softwaretest der Steuerungssoftware des Steuergerätes. In einem ersten Schritt wird die Steuerungssoftware in ein nach dem AUTOSAR-Standard arbeitendes virtuelles Steuergerät eingebunden. Dies kann beispielsweis dadurch erfolgen, dass einige MCAL-Module der Steuerungssoftware des Steuergerätes ausgetauscht werden. Das virtuelle Steuergerät weist einen zusätzlichen Hardware-Layer auf, mit dem wenigstens eine Hardware-Komponente simuliert wird. Insbesondere wird mit dem Hardware-Layer des virtuellen Steuergerätes eine Hardware-Komponente simuliert, die mit dem realen Steuergerät verbindbar ist und/oder mit diesem Signale austauscht. Wenn das reale Steuergerät also beispielsweise mit einem Nockenwellensensor verbindbar ist, wird beim Verfahren zum Testen der Steuerungssoftware des Steuergerätes die Hardware-Komponente Nockenwellensensor simuliert. Das Verfahren weist somit den Vorteil auf, dass es besonders realistische sowie hardware-unabhängige Tests der Steuerungssoftware ermöglicht. Des Weiteren kann das Verfahren besonders einfach verwendet werden, da das virtuelle Steuergerät die gleichen Schnittstellen aufweist, wie das reale Steuergerät. Dementsprechend können auch die gleichen Umgebungsmodelle wie beim HiL-Test verwendet werden. Die in den obigen Abschnitten beschriebenen bevorzugten Weiterbildungen des virtuellen Steuergerätes gelten auch für das Verfahren zum Testen der Steuerungssoftware des Steuergerätes. Die sich daraus ergebenden technischen Effekte und Vorteile sind der Beschreibung des virtuellen Steuergerätes zu entnehmen.

Erfindungsgemäß ist vorgesehen, dass das virtuelle Steuergerät mit einem Umgebungsmodell verbunden ist. Für einen realistischen Test der Steuerungssoftware kann das virtuelle Steuergerät mit einem Umgebungsmodell verbunden sein. Aufgrund des Aufbaus des virtuellen Steuergerätes mit dem zusätzlich einen Hardware-Layer, kann das gleiche Umgebungsmodell verwendet werden, wie in HiL-Tests. Des Weiteren ergeben sich bei hoher Genauigkeit der Simulation geringere Simulationszeiten.

Nachfolgend wird die Erfindung anhand eines bevorzugten Ausführungsbeispiels unter Bezugnahme auf die Zeichnungen weiter im Detail erläutert.

In den Zeichnungen zeigen
- Fig. 1: schematisch ein virtuelles Steuergerät aus dem Stand der Technik und
- Fig. 2: schematisch ein virtuelles Steuergerät, gemäß einem bevorzugten Ausführungsbeispiel der Erfindung

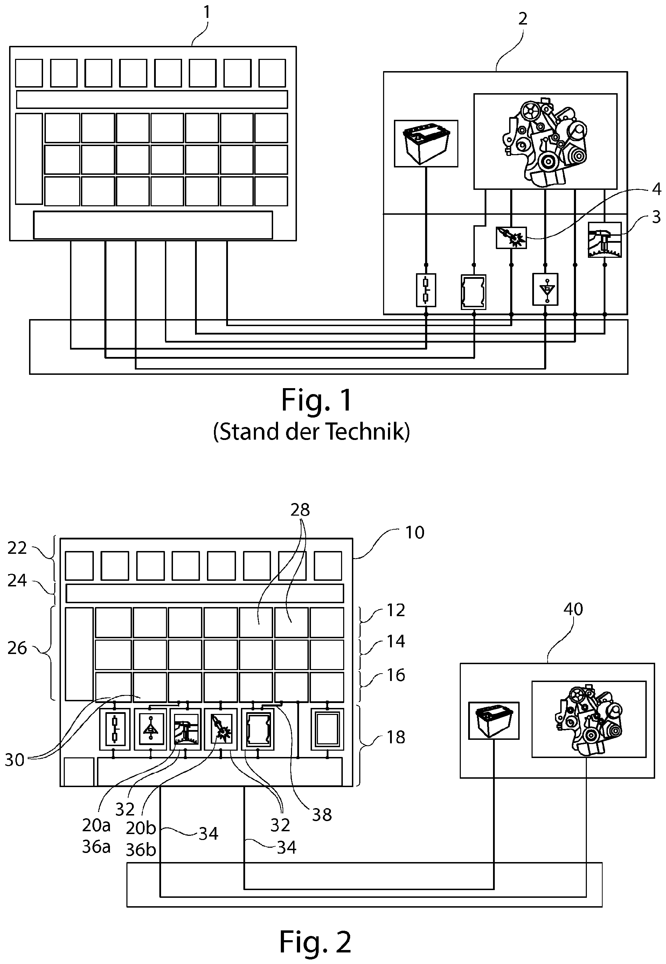

Figur 1 zeigt schematisch ein virtuelles Steuergerät 1, wie es im Stand der Technik bekannt ist. Das virtuelle Steuergerät 1 ist zur Simulation der Motorsteuerung mit einem Umgebungsmodell 2 verbunden. In das Umgebungsmodell 2 sind Hardware-Komponenten-Modelle 3, 4 zur Simulation von Hardware-Komponenten integriert. Im vorliegenden Beispiel des Stands der Technik sind in das Umgebungsmodell 2 ein Kurbelwellensensormodell 3 zur Simulation des Kurbelwellensensors und ein Aktuatormodell 4 zur Simulation des Einspritzventil-Aktuators des Motors integriert.

Figur. 2 zeigt schematisch ein virtuelles Steuergerät 10, gemäß einem bevorzugten Ausführungsbeispiel der Erfindung. Das virtuelle Steuergerät 10 ist nach dem AUTOSAR-Standard aufgebaut und umfass einen Service Layer 12, einen ECU Abstraction-Layer 14, sowie einen Microcontroller Abstraction-Layer 16. Des Weiteren umfasst das virtuelle Steuergerät 10 einen Hardware-Layer 18, wobei der Hardware-Layer 18 zur Simulation wenigstens einer Hardware-Komponente 20 eingerichtet ist. Das virtuelle Steuergerät 10 ist nach dem AUTOSAR Standard aufgebaut, so dass in Figur 2 ebenfalls der Anwendungssoftware-Layer 22 mit der hardwareunabhängigen Anwendungssoftware sowie der Software Abstraction Layer 24, der den Anwendungssoftware-Layer 22 von der hardwareorientierten Basissoftware 26 trennt, gezeigt ist. Der Service Layer 12, der ECU Abstraction-Layer 14, sowie der Microcontroller Abstraction-Layer 16 sind Teil der Basissoftware 26. Die Basissoftware 26 besteht aus mehreren Basissoftwaremodulen 28, wobei die Basissoftwaremodule 28 des Microcontroller Abstraction-Layers 16, als MCAL-Module 30 bezeichnet werden.

Des Weiteren umfasst der Hardware-Layer 18 mehrere Hardware-Layer-Module 32, die gemäß dem AUTOSAR-Standard wie ein Basissoftwaremodul 28 ausgestaltet sind. Jedes Hardware-Layer-Modul 32 ist jeweils zur Simulation einer Hardware-Komponente 20 eingerichtet. Im in Figur 2 gezeigten Ausführungsbeispiel ist ein Hardware-Layer-Modul 32 zur Simulation eines Kurbelwellensensors 20a als Hardware-Komponente 20 und ein anderes Hardware-Layer-Modul 32 zur Simulation eines Einspritzventil-Aktuators 20b als Hardware-Komponente 20 ausgestaltet. Das Hardware-Komponenten-Modell 36, das zur Simulation der Hardware-Komponente 20 berechnet wird, ist also in das Hardware-Layer-Modul 32 integriert. Im vorliegenden Ausführungsbeispiel ist also das Kurbelwellensensormodell 36a und das Einspritzventil-Aktuatormodell 36b in das jeweilige Hardware-Layer-Modul 32 integriert. Durch die Integration der Hardware-Komponenten-Modelle 36 in das virtuelle Steuergerät 10 ergeben sich gleiche Anschlüsse 34 des virtuellen Steuergerätes 10 wie beim realen Steuergerät.

Die MCAL-Module 30 des Microcontroller Abstraction-Layers 16 sind mit den Hardware-Layer-Modulen 32 verbunden. Dies ist in Figur 2 an den Verbindungen 38 gezeigt, so dass eine enge Verzahnung zwischen dem Hardware-Layer 18 und dem Microcontroller Abstraction-Layer 16 vorliegt. Das virtuelle Steuergerät 10 ist des Weiteren zur Simulation mit einem Umgebungsmodell 40 verbunden.

Im Folgenden wird ein Beispiel angegeben, das die Vorteile des erfindungsgemäßen virtuellen Steuergerätes 10 gegenüber dem virtuellen Steuergerät 1 des Stands der Technik hinsichtlich der kürzeren Simulationszeit darlegt:

In diesem Beispiel wird eine Motorregelung mit dem Kurbelwellensensor 20a simuliert. Die Berechnungsrate des Kurbelwellensensormodells 36a muss hoch genug sein, um bei Motordrehzahlen von ca. 6000 Umdrehungen pro Minute noch realistische Ergebnisse zu liefern. Bei einer Auflösung des Kurbelwellensensors 20a von 6 Grad pro Puls ergeben sich für eine Drehzahl von 6000 Umdrehungen pro Minute und für eine Drehzahl von 300 Umdrehungen pro Minute folgende zeitliche Abstände zwischen zwei aufeinanderfolgenden Pulsen:

| Drehzahl [U/min] | Drehzahl [U/sec] | Pulse pro Umdrehung | Pulse pro Sekunde | Zeitlicher Abstand der Pulse |
|---|---|---|---|---|
| 6000 | 100 | 60 | 6000 | 166 µs |
| 300 | 5 | 60 | 300 | 3.33 ms |

Um den Zeitpunkt der Pulse mit genügender Genauigkeit auflösen zu können, sollte die Periodendauer der Sensorsimulation bei ≤ 20 µs liegen, wobei 20 µs bei 6000 Umdrehungen pro Minute immer noch einem variablen Messfehler von ca. +/-0.7 Grad bzw. von +/-12 % entsprechen.

Die folgende Tabelle zeigt für jede Komponente in der Signalkette typische Periodendauern, wobei sich die linke Spalte auf ein virtuelles Steuergerät 1 nach dem Stand der Technik, welches in Figur 1 gezeigt ist, bezieht und die rechte Spalte auf das erfindungsgemäße virtuelle Steuergerät 10 aus Figur 2.

| | Virtuelles Steuergerät 1 nach dem Stand der Technik: Integration des Sensormodells in das Umgebungsmodell | Erfindungsgemäßes virtuelles Steuergerät 10: Integration des Sensormodells in das virtuelle Steuergerät |
|---|---|---|
| Komponente | Periodendauer | Periodendauer |
| Simulationsplattform | 20 µs | 1 ms |
| Motormodell | 20 µs | 1 ms |
| Sensormodell | 20 µs | 20 µs |
| MCAL Treiber | 20 µs | eventbasiert 166 µs ... 3.33 ms |
| Steuergeräte Tasks | eventgetriebene Tasks 166 µs - 3.33 ms + andere Tasks | eventgetriebene Tasks 166 µs - 3.33 ms + andere Tasks |

Beim virtuellen Steuergerät 1 nach dem Stand der Technik bildet das Sensormodell für den Kurbelwellensensor zusammen mit dem Motormodell ein kontinuierliches System, dessen Teile mit einer gemeinsamen Berechnungsrate, also mit einer gemeinsamen Periodendauer von 20 µs simuliert werden. Die Simulationsplattform des virtuellen Steuergeräts triggert den Umgebungsmodell-Prozess mit einer Periodendauer von 20 µs. Auch das virtuelle Steuergerät des Stands der Technik muss mit derselben Periodendauer getriggert werden, um einen eventuell vom Umgebungsmodell gesendeten Sensor-Puls zu verarbeiten. Die gesamte Datenkommunikation aller Signale zwischen dem virtuellen Steuergerät und dem Umgebungsmodell erfolgt in dieser gemeinsam Berechnungsrate mit einer Periodendauer von 20 µs. In anderen Worten: Nicht nur das Umgebungsmodell muss in diesem Fall also mit einer hohe Berechnungsrate gerechnet werden, sondern auch das virtuelle Steuergerät, das die Signale abtastet. Die sehr aufwändige Inter-Prozess-Kommunikation muss ebenfalls mit 20 µs Periodendauer erfolgen. Allein der Aufwand für den Prozesswechsel ist oft aufwändiger als die Berechnung des Sensormodells. Zusammengefasst bewirken die hohen Berechnungsraten eine sehr hohe Gesamtsimulationszeit.

Beim erfindungsgemäßen virtuellen Steuergerät 10 ist das Sensormodell 36a des Kurbelwellensensors 20a in das virtuelle Steuergerät 10 integriert. Dies ermöglicht, einzelne Sensormodelle unabhängig von den anderen Sensormodellen und unabhängig vom Umgebungsmodell 40 mit einer hohen Berechnungsrate zu berechnen. Das Umgebungsmodell 40 kann abhängig von den Motorzeitkonstanten (träge Masse) mit einer typischen Periodendauer von 1 ms gerechnet werden, was den Aufwand dieses Prozesses im Vergleich zum Stand der Technik um den Faktor 50 reduziert. Innerhalb des virtuellen Steuergerätes 10 wird nur das relativ kleine Sensormodell 36a mit der erhöhten Berechnungsrate mit einer Periodendauer von 20 µs berechnet. Die weitere Software im virtuellen Steuergerät 10 wird in periodischen oder eventgetriebenen Tasks mit der jeweils normalen Periodendauer berechnet. Die hohe Berechnungsrate ist also auf einen kleinen Teil des virtuellen Steuergeräte-Prozesses begrenzt, das heißt die Gesamtrechenzeit nimmt kaum zu. Auch die Simulationsplattform erzeugt Trigger in einer üblichen Berechnungsrate mit einer Periodendauer von 166 µs - 1 ms. Die Datenkommunikation zwischen dem virtuellen Steuergerät und dem Umgebungsmodell erfolgt ebenfalls in dieser Berechnungsrate. Das erfindungsgemäße virtuelle Steuergerät 10 ist somit um einige Größenordnungen effizienter, schneller sowie flexibler als das virtuelle Steuergerät 1 gemäß dem Stand der Technik.

**Bezugszeichenliste**

| | | |
|---|---|---|
| 1 | virtuelles Steuergerät | (Stand der Technik) |
| 2 | Umgebungsmodell | (Stand der Technik) |
| 3 | Kurbelwellensensormodell | (Stand der Technik) |
| 4 | Aktuatormodell | (Stand der Technik) |
| | | |
| 10 | virtuelles Steuergerät | |
| 12 | Service Layer | |
| 14 | ECU Abstraction-Layer | |
| 16 | Microcontroller Abstraction-Layer | |
| 18 | Hardware-Layer | |
| 20 | Hardware-Komponente | |
| 20a | Kurbelwellensensor | |
| 20b | Einspritzventil-Aktuator | |
| 22 | Anwendungssoftware-Layer | |
| 24 | Software Abstraction Layer | |
| 26 | Basissoftware | |
| 28 | Basissoftwaremodul | |
| 30 | MCAL-Modul | |
| 32 | Hardware-Layer-Modul | |
| 34 | Anschlüsse | |
| 36 | Hardware-Komponenten-Modell | |
| 36a | Kurbelwellensensormodell | |
| 36b | Einspritzventil-Aktuatormodell | |
| 38 | Verbindungen | |
| 40 | Umgebungsmodell | |

## Patentansprüche

1. Virtuelles Steuergerät (10) nach dem AUTOSAR-Standard, mit
einem Service-Layer (12),
einem ECU Abstraction-Layer (14) und
einem Microcontroller Abstraction-Layer (16),
zum Absichern der Steuerungssoftware eines Steuergerätes durch reproduzierbare Tests, wobei das virtuelle Steuergerät (10) mit einem Umgebungsmodell verbunden ist, **dadurch gekennzeichnet, dass** das virtuelle Steuergerät (10) zusätzlich einen Hardware-Layer (18) aufweist, der zur Simulation wenigstens einer Hardware-Komponente (20) eingerichtet ist,
wobei die virtuelle Hardware-Komponente (20) ein virtueller Sensor, Aktuator und/oder Steuergeräte-Netzwerk ist,
wobei die virtuelle Hardware-Komponente (20) als ein Hardware-Komponenten-Modell (36) in den Hardware-Layer (18) integriert ist,
wobei das Hardware-Komponenten-Modell (36) für ein Eingangssignal den zugehörigen Ausgabewert und somit das Ergebnis der Simulation der Hardware-Komponente (20) berechnet,
wobei die Hardware-Komponente (20) mit unterschiedlicher Berechnungsrate simulierbar ist,
wobei eine Berechnungsrate des Hardware-Komponenten-Modells (36) frei wählbar ist, wobei während der Simulation eine Berechnungsrate des Umgebungsmodells (40) von der Berechnungsrate des Hardware-Komponenten-Modells (36) abweicht,
wobei das Umgebungsmodell während der Simulation Signale mit dem virtuellen Steuergerät austauscht,
wobei eine Rate, mit der die Signale zwischen dem Umgebungsmodell (40) und dem virtuellen Steuergerät (10) übertragen werden, kleiner oder gleich der Berechnungsrate des Umgebungsmodells (40) ist.

2. Virtuelles Steuergerät (10) nach Anspruch 1, **dadurch gekennzeichnet, dass** der Hardware-Layer (18) mehrere Hardware-Layer-Module (32) umfasst, die gemäß dem AUTOSAR-Standard wie ein Basissoftwaremodul (28) ausgestaltet sind.

3. Virtuelles Steuergerät (10) nach Anspruch 2, **dadurch gekennzeichnet, dass** jeweils ein Hardware-Layer-Modul (32) zur Simulation jeweils einer Hardware-Komponente (20) eingerichtet ist.

4. Virtuelles Steuergerät (10) nach Anspruch 2 oder 3, **dadurch gekennzeichnet, dass** der Microcontroller Abstraction-Layer (16) mehrere MCAL-Module (30) umfasst, wobei die MCAL-Module (30) mit den Hardware-Layer-Modulen (32) verbindbar sind.

5. Virtuelles Steuergerät (10) nach einem der vorhergehenden Ansprüche, **dadurch gekennzeichnet, dass** der Hardware-Layer (18) derart ausgestaltet ist, dass Ereignisse innerhalb des virtuellen Steuergerätes (10) erzeugbar sind,
wobei ein Ereignis ein Zeitpunkt ist, an dem der normale Programmablauf unterbrochen wird,
wobei das Ereignis für eine simulierte Hardware-Komponente (20) innerhalb des Hardware-Layers erzeugt wird,
wobei das Ereignis mit einer hohen zeitlichen Genauigkeit erzeugt wird.

6. Virtuelles Steuergerät (10) nach einem der vorhergehenden Ansprüche, **dadurch gekennzeichnet, dass** der Hardware-Layer (18) zur Simulation mehrerer Hardware-Komponenten (20) eingerichtet ist, wobei die einzelnen Hardware-Komponenten (20) gleichzeitig mit unterschiedlichen Berechnungsraten simulierbar sind, wobei die Berechnungsraten der einzelnen Hardware-Komponenten-Modelle (36) frei wählbar sind.

7. Virtuelles Steuergerät (10) nach einem der vorhergehenden Ansprüche, **dadurch gekennzeichnet, dass** während der Simulation zwischen dem Umgebungsmodell (40) und dem virtuellen Steuergerät (10) Signale auf einem physikalischen Niveau ausgetauscht werden.

## Claims

1. A virtual control device (10) according to the AUTOSAR
standard, having a service layer (12),
an ECU abstraction layer (14), and
a microcontroller abstraction layer (16),
for securing the control software of a control device by means of reproducible tests, the virtual control device (10) being connected to an environmental model,
**characterized in that** the virtual control device (10) further comprises a hardware layer (18) set up for simulating at least one hardware component (20),
wherein the virtual hardware component (20) is a virtual sensor, actuator, and/or control device network,
wherein the virtual hardware component (20) is integrated in the hardware layer (18) as a hardware component model (36), wherein the hardware component model (36) calculates the associated output value for an input signal and thus the result of the simulation of the hardware component (20),
wherein the hardware component (20) can be simulated at different calculation rates,
wherein a calculation rate of the hardware component model (36) can be freely selected,
wherein a calculation rate of the environment model (40) during the simulation deviates from the calculation rate of the hardware component model (36),
wherein the environment model exchanges signals with the virtual control device during the simulation,
wherein a rate at which the signals are transferred between the environment model (40) and the virtual control device (10) is less than or equal to the calculation rate of the environment model (40).

2. The virtual control device (10) according to claim 1, **characterized in that** the hardware layer (18) comprises a plurality of hardware layer modules (32) implemented as a base software module (28) according to the AUTOSTAR standard.

3. The virtual control device (10) according to claim 2, **characterized in that** one hardware layer module (32) is set up for simulating one hardware component (20) each.

4. The virtual control device (10) according to claim 2 or 3, **characterized in that** the microcontroller abstraction layer (16) comprises a plurality of MCAL modules (30), wherein the MCAL modules (30) can be connected to the hardware layer modules (32) .

5. The virtual control device (10) according to any one of the preceding claims, **characterized in that** the hardware layer (18) is implemented such that events can be created within the virtual control device (10),
wherein an event is a point in time at which the normal program sequence is interrupted,
wherein the event is created for a simulated hardware component (20) within the hardware layer,
wherein the event is created having a high time precision.

6. The virtual control device (10) according to any one of the preceding claims, **characterized in that** the hardware layer (18) is set up for simulating a plurality of hardware components (20), wherein the individual hardware components (20) can be simulated simultaneously at different calculation rates, wherein the calculation rates of the individual hardware component models (36) can be freely selected.

7. The virtual control device (10) according to any one of the preceding claims, **characterized in that** signals are exchanged at a physical level between the environment model (40) and the virtual control device (10) during the simulation.

## Revendications

1. Appareil de commande virtuel (10) selon la norme AUTOSAR,
comportant une couche de service (12),
une couche d'abstraction ECU (14) et
une couche d'abstraction de microcontrôleur (16),
destinée à sauvegarder le logiciel de commande d'un appareil de commande par des tests reproductibles, sachant que l'appareil de commande virtuel (10) est relié à un modèle d'environnement,
**caractérisé en ce que** l'appareil de commande virtuel (10) comprend en outre une couche matérielle (18) qui est configurée pour simuler au moins un composant matériel (20), sachant que le composant matériel virtuel (20) est un capteur, un actionneur et/ou un réseau d'appareils de commande virtuel(s),
sachant que le composant matériel virtuel (20) est intégré dans la couche matérielle (18) sous la forme d'un modèle de composant matériel (36),
sachant que le modèle de composant matériel (36) calcule pour un signal d'entrée la valeur de sortie correspondante et donc le résultat de la simulation du composant matériel (20), sachant que le composant matériel (20) peut être simulé à une vitesse de calcul différente,
sachant qu'une vitesse de calcul du modèle de composant matériel (36) peut être choisie librement,
sachant que, pendant la simulation, une vitesse de calcul du modèle d'environnement (40) diffère de la vitesse de calcul du modèle de composant matériel (36),
sachant que le modèle d'environnement échange des signaux avec l'appareil de commande virtuel pendant la simulation,
sachant qu'une vitesse à laquelle les signaux sont transmis entre le modèle d'environnement (40) et l'appareil de commande virtuel (10) est inférieure ou égale à la vitesse de calcul du modèle d'environnement (40).

2. Appareil de commande virtuel (10) selon la revendication 1, **caractérisé en ce que** la couche matérielle (18) comprend plusieurs modules de couche matérielle (32) qui sont conçus comme un module de logiciel de base (28) selon la norme AUTOSAR.

3. Appareil de commande virtuel (10) selon la revendication 2, **caractérisé en ce que**, respectivement, un module de couche matérielle (32) est configuré pour simuler respectivement un composant matériel (20).

4. Appareil de commande virtuel (10) selon la revendication 2 ou 3, **caractérisé en ce que** la couche d'abstraction de microcontrôleur (16) comprend plusieurs modules MCAL (30), sachant que les modules MCAL (30) peuvent être connectés aux modules de couche matérielle (32).

5. Appareil de commande virtuel (10) selon l'une quelconque des revendications précédentes, **caractérisé en ce que** la couche matérielle (18) est conçue de sorte que des événements puissent être générés à l'intérieur de l'appareil de commande virtuel (10),
sachant qu'un événement est un instant auquel le déroulement normal du programme est interrompu,
sachant que l'événement est généré à l'intérieur de la couche matérielle pour un composant matériel (20) simulé,
sachant que l'événement est généré avec une précision temporelle élevée.

6. Appareil de commande virtuel (10) selon l'une quelconque des revendications précédentes, **caractérisé en ce que** la couche matérielle (18) est configurée pour simuler plusieurs composants matériels (20), sachant que les différents composants matériels (20) peuvent être simulés simultanément à des vitesses de calcul différentes, sachant que les vitesses de calcul des différents modèles de composants matériels (36) peuvent être choisies librement.

7. Appareil de commande virtuel (10) selon l'une quelconque des revendications précédentes, **caractérisé en ce que**, pendant la simulation, des signaux sont échangés à un niveau physique entre le modèle d'environnement (40) et l'appareil de commande virtuel (10).
